# EUROPEAN PATENT SPECIFICATION

(11) **EP 4 319 514 B1**
(45) Date of publication and mention of the grant of the patent: **28.01.2026**
(21) Application number: 22188929.8
(22) Date of filing: 05.08.2022
(51) Int. Cl.: H05K 5/00

(54) **ELECTRONIC CONTROL UNIT WITH A BACK-UP POWER SUPPLY**
ELEKTRONISCHE STEUEREINHEIT MIT EINER NOTSTROMVERSORGUNG
UNITÉ DE COMMANDE ÉLECTRONIQUE DOTÉ D'UNE ALIMENTATION ÉLECTRIQUE DE SECOURS

(43) Date of publication of application: 07.02.2024
(73) Proprietor: Veoneer Sweden Safety Systems AB, 10302 Stockholm (SE)
(72) Inventor: SAVIN, Anatolie, 700051 Iasi (RO); CACU, Adrian, 700051 Iasi (RO)
(74) Representative: Reichert & Lindner Partnerschaft Patentanwälte

(56) References cited:
- US-A- 6 163 460
- US-A1- 2003 199 195
- US-A1- 2011 244 712
- US-A1- 2018 242 460

## Description

### FIELD OF THE INVENTION

The invention relates to an electronic control unit with a back-up power supply. The electronic control unit is defined by at least two capacitors, wherein the at least two capacitors are accommodated in a housing part of the electronic control unit. Each capacitor has a first electric line and a second electric line.

### DESCRIPTION OF THE BACKGROUND ART

US 2021/012972 A1 relates to a mounting structure for mounting an electrolytic capacitor on a printed circuit board (PCB) of an airbag electronic control unit (ECU) including a cap for receiving a lead end of the capacitor. The cap includes openings for receiving electrical leads of the capacitor. The cap supports electrical connectors which electrically contact the electrical leads when a lead end of the capacitor is installed in the cap. The electrical connectors include portions for interfacing with the PCB to electrically connect the electrical connectors to the PCB.

US 2003/199195 A1 discloses an electronic control unit (control box) having the features of the preamble of claim 1.

US 2018/242460 A1 discloses a connector module used in a controller, wherein the electrolytic capacitors share a common receiving element.

US 2011/244712 A1 discloses an electrical appliance including a housing having a holding chamber and an insert slot, an insulation displacement connector (IDC), and an electrical component such as a battery inserted into the holding chamber. The component has an electric connector extending through the holding chamber into the insert slot. Upon insertion of the IDC into the insert slot, the IDC contacts the electric connector of the component and contacts a printed circuit board (PCB) mounted to the housing whereby the electrical component and the PCB are electrically connected via the electric connector of the component and the IDC.

US 6 163 460 A discloses an arrangement of electronic components in a housing including the housing, at least one circuit board arranged in the housing with electronic components of a first type (such as SMDs) mounted thereon, at least one electronic component of a second type (such as a non-SMD coil or capacitor) that is not arranged on the circuit board but rather is mounted on a mounting surface in the housing, and an electrical connection established between the second electronic component and the circuit board. The electrical connection may be established by a connector member having two connecting shanks connected to the wires of the second component and two mounting shanks that are press-fit into contact holes of the circuit board. Alternatively, the electrical connection may be established by respective contact clips electrically and mechanically clamped onto the wires of the second component, whereby the contact clips have contact pins that plug into contact holes in the circuit board.

As known, an electrical control unit (ECU) is an embedded electronic device. A typical ECU consists of a printed circuit board (PCB), a housing part with a bottom, a cover and, in some cases, a back-up power unit. It is necessary to ensure that the ECU is supplied with power even in cases where the main power unit has a malfunction. For this reason, the back-up power unit is provided, which is often a relatively heavy capacitor. In the case of plastic housings, the fixation of the back-up power unit is realized via a mounting structure, also called a "cradle", with a plastic snap-fit solution. The mounting structure is an integral part of the bottom of a plastic housing part.

Airbags ECUs require energy reserve capacitors to operate and send deployment signals to pyrotechnic devices embedded in airbag cushions or seatbelt mechanisms in the event that the power line between the ECU and the vehicle battery is interrupted as a result of a collision.

Some airbag ECUs use a single capacitor that is shorter or longer depending on the amount of energy required. If the required energy is greater than what one capacitor can provide, two or more capacitors are used. As safety regulations become more stringent, the number of airbags increases, and so does the amount of required energy reserve. The point is that two or more capacitors will be widely used in airbag ECUs in the near future.

### SUMMARY OF THE INVENTION

It is an object of the present invention to provide an electronic control unit with an increased back-up power ability, a compact design and a reduction of costs and material.

The above object is achieved by an electronic control unit according to the features of claim 1.

In an embodiment, an electronic control unit comprises a back-up power supply defined by at least two capacitors, wherein the at least two capacitors are accommodated in a housing part of the electronic control unit, and each capacitor has a first electric line and a second electric line. According to an embodiment of the present invention, the electronic control unit has a first insulation displacement connector positioned in a first tower. Additionally, the electronic control unit has a second insulation displacement connector positioned in a second tower. The first electric line of each capacitor is connected to the first insulation displacement connector, and the second electric line is connected to the second insulation displacement connector.

The advantage of the embodiment is that the number of required insulation displacement connectors is reduced, which not only saves space on the housing part of the electronic control unit, but also saves production costs and material. Moreover, the arrangement of the capacitors on the housing part can be made in a more compact manner.

The capacitor package becomes more compact because some insulation displacement connectors and the corresponding towers for insulation displacement connectors are eliminated. Since the number of towers and the number of capacitors determine the module size, this means the overall dimension of the electronic control unit will decrease when using the same insulation displacement connectors and towers for multiple capacitors.

The first insulation displacement connector and the second insulation displacement connector each have a plurality of slots. The number of slots corresponds to the number of capacitors forming the back-up power supply. The first insulation displacement connector and the second insulation displacement connector may be inserted into a slide of the first tower and the second tower, respectively. In an embodiment, a first support and a second support are provided on both sides of the slide of the first tower and the second tower. The first support and the second support are used as a support for the first and second electric lines from the number of capacitors, respectively.

In an embodiment, a plurality of grooves are formed in the first support and in the second support of the first tower for supporting the first electric line from the capacitors. A plurality of grooves is formed in the first support and in the second support of the second tower for supporting the second electric line from the capacitors.

The inserted first insulation displacement connector electrically contacts the first electric lines from each capacitor. The inserted second insulation displacement connector electrically contacts the second electric lines from each capacitor.

The grooves have the advantage of orienting, aligning and supporting the first electric lines and the second electric lines so that they are oriented and aligned with respect to the slots of the first and second insulation displacement connectors when the same are inserted into the slots.

The capacitors are connected in parallel when the first electric lines of each capacitor are connected through the first insulation displacement connector and when the second electric lines of each capacitor are connected through the second insulation displacement connector. The voltage applied to all capacitors connected in parallel is the same. The capacitors connected in parallel have a "common voltage" supply.

According to one embodiment, the first insulation displacement connector and the second insulation displacement connector each have a plate-shaped form which fits into the slide of the first tower. The inserted first insulation displacement connector and the inserted second insulation displacement connector contact the first electric lines and the second electric lines from the capacitors, respectively. The electric contact is carried out with the slots in the plate-shaped form of the first insulation displacement connector and the inserted second insulation displacement connector. Each of the slots of the first insulation displacement connector and the second insulation displacement connector is delimited by a pair of fingers.

According to one embodiment of the first and second insulation displacement connector, both have three fingers, which may look like a fork with three fingers, and two slots. As mentioned above, the slots can receive the first electric line (lead) or the second electric line (lead). The first electric line and the second electric line are parallel. In a further embodiment, the first and second insulation displacement connector each have four fingers and three slots.

According to a further embodiment of the invention, a third support is provided. The third support is separate from the first support of the first tower and the second tower, respectively. In an embodiment, the first support, the second support and the third support of the first tower have at least one groove formed to support the first electric lines from the capacitors. Additionally, at least one groove is formed in the first support, the second support and the third support of the second tower for supporting the second electric lines from the capacitors.

Accordingly, in an embodiment, the first insulation displacement connector and the second insulation displacement connector are composed of a first plate-shaped form and a second plate-shaped form. Both are parallel to each other and electrically and mechanically connected with a bracket. In case the electronic control unit is equipped with two capacitors, the first plate-shaped form and the second plate-shaped form each have at least one slot adjoined by respective two fingers.

It is possible as well that the electronic control unit has three capacitors. According to this design, the first plate-shaped form and the second plate-shaped form have one slot, wherein each slot is adjoined by two respective fingers. The embodiment of the double insulation displacement connector (first plate-shaped form and parallel second plate-shaped form) have two fingers with one slot. Each insulation displacement connector is capable to receive two first or second electric lines from each of the two capacitors. The first or second electric lines are arranged in a line or may also have an offset.

In case the electronic control unit holds three capacitors, the first plate-shaped form and the second plate-shaped form have two slots, wherein each slot is adjoined by two fingers.

The insulation displacement connector having the first plate-shaped form parallel to the second plate-shaped form looks substantially the same as the insulation displacement connector having the single plate-shaped form. One plate-shaped form of the insulation displacement connector sits with an interference fit in the slot of the first or second tower. The first plate-shaped form and the second plate-shaped are connected by a thin bracket of U-shaped material.

According to the principle already mentioned, the slots of the first plate-shaped form and the second plate-shaped form, when inserted in the first tower, contact the first electric lines from the capacitors. Additionally, the slots of the first plate-shaped form and the second plate-shaped form, when inserted in the second tower, contact the second electric lines from the capacitors.

In an embodiment, at least one groove is formed in the first support, the second support and the third support of the first tower and the second tower to support and position the first and second electric lines from the capacitors. The grooves are aligned with each other. In case the electronic control unit holds two capacitors, the first plate-shaped form and the second plate-shaped form of each insulation displacement connector have one slot. The first support, the second support and the third support of the first tower and the second tower each have one single groove.

In case the electronic control unit holds three capacitors, the first plate-shaped form and the second plate-shaped form of each insulation displacement connector have two slots. The first support, the second support and the third support of the first tower and the second tower have two parallel grooves.

The designs of the insulation displacement connector according to the first or second design are suitable for reel packaging. More embodiments of the electronic control unit are possible by varying the way the capacitors are arranged relative to each other in the housing part. Additionally, more designs of the insulation displacement connector are possible, depending on the bending type of the first and second electric lines leads (90° bend, straight, S-bend).

The inventive embodiments of the electronic control unit have several advantages. According to the invention, the number of insulation displacement connectors is lowered from four to two insulation displacement connectors, if two capacitors are sharing the same insulation displacement connectors. In case three capacitors need to be connected with each other, the insulation displacement connectors each have three slots. Here as well, two insulation displacement connectors are used instead of six. In this way, assembly costs and the assembly time are reduced.

Additionally, according to the invention, the capacitor package in the housing part of the electronic control unit becomes more compact as some insulation displacement connectors and corresponding towers for insulation displacement connectors are eliminated. If the capacitor number determines the size of the electronic control unit, this means that the overall module dimension is reduces with the usage of same insulation displacement connectors for multiple capacitors.

A keep-out area of 3mm for all types of components and 5mm for sensitive components must be maintained around each connector (pin) of the insulation displacement connectors on both sides of the printed circuit board. If the number of insulation displacement connectors is reduced, there will be considerably more space on the printed circuit board for components layout. By reducing the size of the printed circuit board, the size of the electronic control unit can be further reduced.

Using the same mounting structures (cradles), capacitors, slightly modified connectors of the insulation displacement connector and towers for the insulation displacement connector, the same tools for bending and trimming of the first and second electric lines result in minimal changes to the overall architecture, which means easy implementation, minimal testing, low risks, increased confidence, etc.

### BRIEF DESCRIPTION OF THE DRAWINGS

The numerous advantages of the disclosure may be better understood by those skilled in the art by reference to the accompanying figures in which:
Figure 1 shows a schematic representation of the placement of an embodiment of an electronic control unit (ECU) in a vehicle.
Figure 2 is a perspective view of an embodiment of an ECU using insulation displacement connectors (IDCs) to electronically connect two capacitors that function as a back-up power supply.
Figure 3 is a detailed side view of two IDCs positions in respective towers for the IDCs.
Figure 4 is a detailed perspective view of an IDC used in relation with the present invention.
Figure 5 is a detailed perspective view of an embodiment of a prior art IDC.
Figure 6 is a perspective view of a further embodiment of an ECU in which the IDCs and the tower for the IDCs are designed to electronically connect two capacitors to function as a back-up power supply.
Figure 7 is a top view of the arrangement of the IDCs (embodiment shown in Figs. 8 and 9) in the respective IDC towers.
Figures 8 and 9 show perspective views of the IDC used in the embodiment of Fig. 6.
Figure 10 is sectional top view showing the arrangement of the connectors to the capacitors in an IDC tower.
Figure 11 is a detailed sectional view of two IDCs according to the embodiment of Fig. 8 and 9 in respective towers for the IDCs.
Figure 12 is a perspective view of IDC towers according to a prior art embodiment.
Figure 13 is a perspective view of IDC towers for receiving the IDCs according to Fig. 5.
Figure 14 is a perspective view of IDC towers for receiving the IDCs according to Fig. 8 and 9.

### DETAILED DESCRIPTION

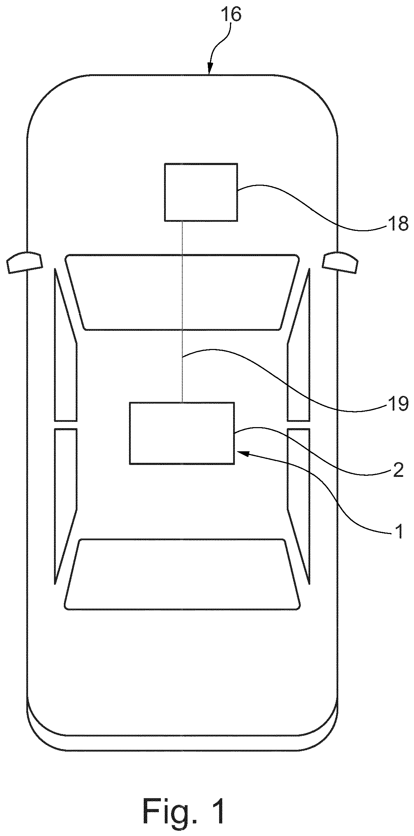

**Figure 1** shows a schematic representation of an embodiment of a placement of an electronic control unit (ECU) **1** for a vehicle **16.** Electronic control unit **1** controls one or more electrical systems of vehicle **16** and is enclosed by a housing **2.** Housing **2** may be made of plastics or metallic materials. In cases where vibrations are more extreme during use of vehicle **16,** housing **2** may be made of metallic materials, such as die-cast aluminium. To provide electrical power to ECU **1,** ECU **1** is electrically connected to a vehicle battery **18** (main battery), typically via an electric line **19.** To ensure a permanent supply of electric power to the ECU **1** is connected with a back-up power unit, which is configured in the form of a capacitor. The relatively heavy capacitor must be mounted in the housing **2** of the ECU **1** to ensure back-up power supply in all traffic situations.

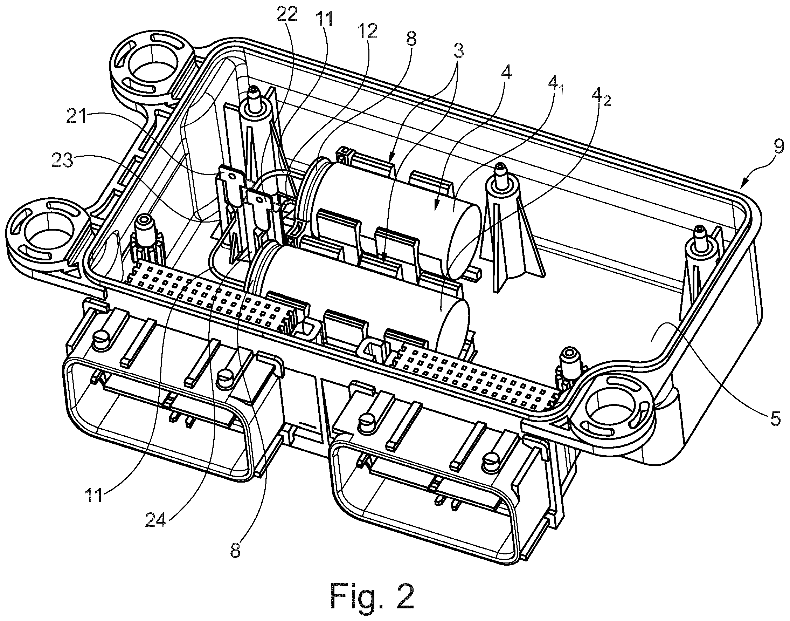

**Figure 2** shows a perspective view of an embodiment of a housing part **9** for a housing **2** of an ECU **1** (see Fig. 1) for accommodating at least a first capacitor **4₁** and a second capacitor **4₂**. Bottom **5** of housing part **9** has a mounting structure **3** for each capacitor **4₁** and **4₂,** which is an integral part of the housing part **9.** Each capacitor **4₁** and **4₂**, has a first electric line **11** and a second electric line **12.** The first electric line **11** of each capacitor **4₁** and **4₂** is in electric contact with a first insulation displacement connector **21.** The second electric line **12** of each capacitor **4₁** and **4₂** is in electric contact with a second insulation displacement connector **22.** To achieve a stable and reliable electric connection of each capacitor **4₁** and **4₂** with the first insulation displacement connector **21** and the second insulation displacement connector **22,** both of them are inserted into a first tower **23** and a second tower **24,** respectively. The first tower **23** and the second tower **24** are as well integral parts of housing part **9.**

In case housing part **9** is made of plastic, at least the mounting structures **3,** the first tower **23** and the second tower **24** are formed as integral parts of bottom **5** of housing part **9** during the injection moulding process. Once capacitors **4₁** and **4₂** are positioned in mounting structure **3,** a circumferential notch **8** of each of the capacitors **4₁** and **4₂** helps align the first electric line **11** and the second electric line **12** of capacitors **4₁** and **4₂** with respect to the first tower **23** and the second tower **24,** respectively. Additionally, the circumferential notch **8** and the corresponding geometry of mounting structure **3** (cradle) have the role to prevent the accidental slip of the capacitors **4₁** and **4₂** out of the mounting structure **3** when drop tested along an axial direction of the of the capacitors **4₁** and **4₂**.

For the purpose of the description, the embodiments described herein are limited to a first capacitor **4₁** and a second capacitor **4₂**. It is obvious to those skilled in the art that housing part **9** may accommodate more than two capacitors as a back-up power supply **4.**

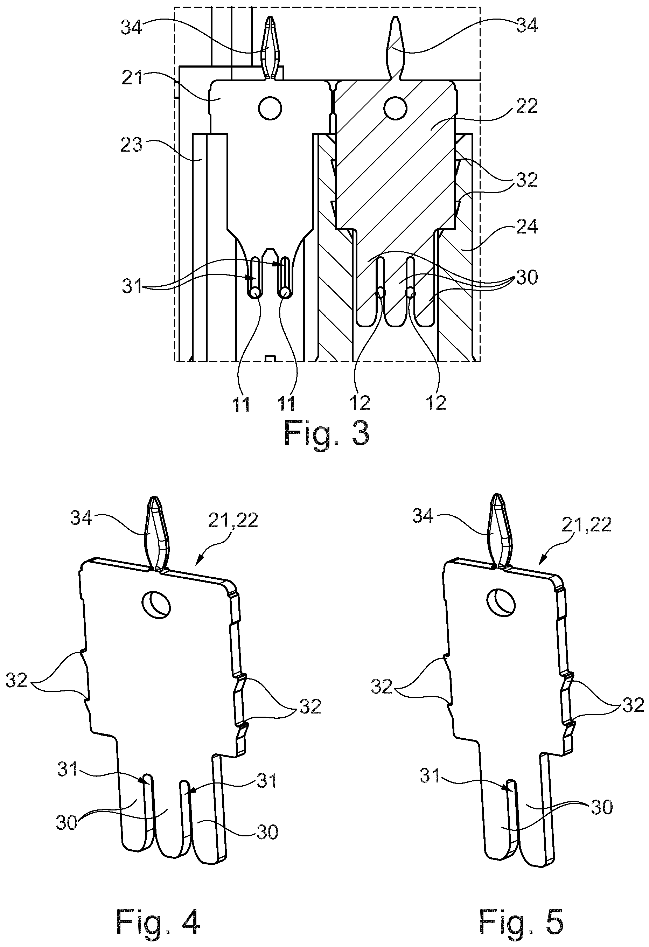

**Figure 3** is a detailed view of the first tower **23** with an inserted first insulation displacement connector **21** and the second tower **24** with an inserted second insulation displacement connector **22.** Second tower **24** is partially cut out to show the mounting of second insulation displacement connector **22** in second tower **24.** In this embodiment, first insulation displacement connector **21** and second insulation displacement connector **22** have three fingers **30** and two slots **31.** The slots **31** are formed between the three fingers **30.**

According to the embodiment shown in **Figure 4****,** insulation displacement connectors **21** and **22** each have three fingers **30** defining two (three minus one) slots **31.** The slots **31** of first insulation displacement connector **21** are suitable for receiving the first electric lines **11** of first capacitor **4₁** and second capacitor **4₂**. The slots **31** of second insulation displacement connector **22** are suitable for receiving the second electric lines **12** of first capacitor **4₁** and second capacitor **4₂**. The first electric lines **11** the second electric lines **12** run in parallel in the region of the slots **31** of first insulation displacement connector **21** and second insulation displacement connector **22.** It is obvious that the insulation displacement connectors **21** and **22** are not limited to three fingers **30** and two slots **31.** The number of capacitors **4₁**, **4₂**,..., **4_{N}** determines the number of slots **31** formed in the insulation displacement connectors **21** and **22.** If the insulation displacement connectors **21** and **22** have a number L (greater than three) of fingers **30,** the insulation displacement connectors **21** and **22** have L-1 slots **31.**

A possible further embodiment, not shown, is that the first insulation displacement connector **21** and the second insulation displacement connector **22** each have four fingers **30** between which three (four minus one) slots **31** are formed. This embodiment allows the electric connection of three capacitors **4₁**, **4₂** and **4₃** to first insulation displacement connector **21** and second insulation displacement connector **22** to form a back-up power supply with increased back-up power.

In **Figure 4****,** a perspective view of the first insulation displacement connector **21** or the second insulation displacement connector **22** according to an embodiment of the invention shows that the first insulation displacement connector **21** and the second insulation displacement connector **22** have barbed hooks **32.** Each insulation displacement connector **21** or **22** is provided with a connector **34** to the printed circuit board (not shown) to deliver back-up power.

A prior art embodiment of the first insulation displacement connector **21** or the second insulation displacement connector **22** is shown in **Figure 5****.** This prior art embodiment has two fingers **30** in which one slot **31** is formed. Only a single electric line (not shown) can be connected to this prior art embodiment.

The barbed hooks **32** cooperate with the first tower **23** and the second tower **24** to ensure a secure and permanent fit of the first insulation displacement connector **21** and the second insulation displacement connector **22** in the first tower **23** and the second tower **24.**

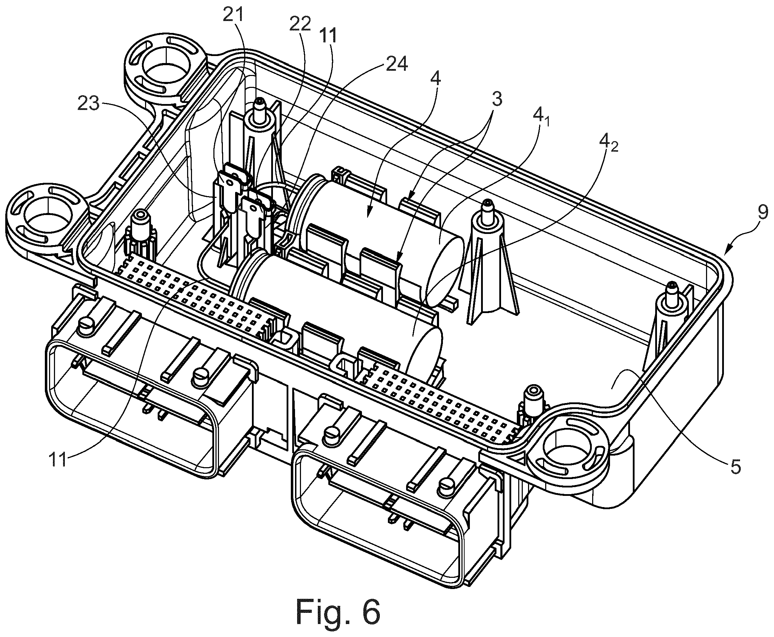

**Figure 6** shows a perspective view of a further embodiment of a housing part **9** for a housing **2** of an ECU **1** (see Fig. 1) for accommodating at least a first capacitor **4₁** and second capacitor **4₂**. First capacitor **4₁** and second capacitor **4₂** are mounted to bottom **5** of housing part **9** by mounting structure **3.** Each capacitor **4₁** and **4₂** has a first electric line **11** and a second electric line **12.** The first electric line **11** of each capacitor **4₁** and **4₂** is in electric contact with the first insulation displacement connector **21** according to a further embodiment. The second electric line **12** of each capacitor **4₁** and **4₂** is in electric contact with the second insulation displacement connector **22** according to this embodiment. The mounting structure **3** for capacitors **4₁** and **4₂**, the first tower **23** and the second tower **24** are integral parts of the bottom 5 of housing part **9.**

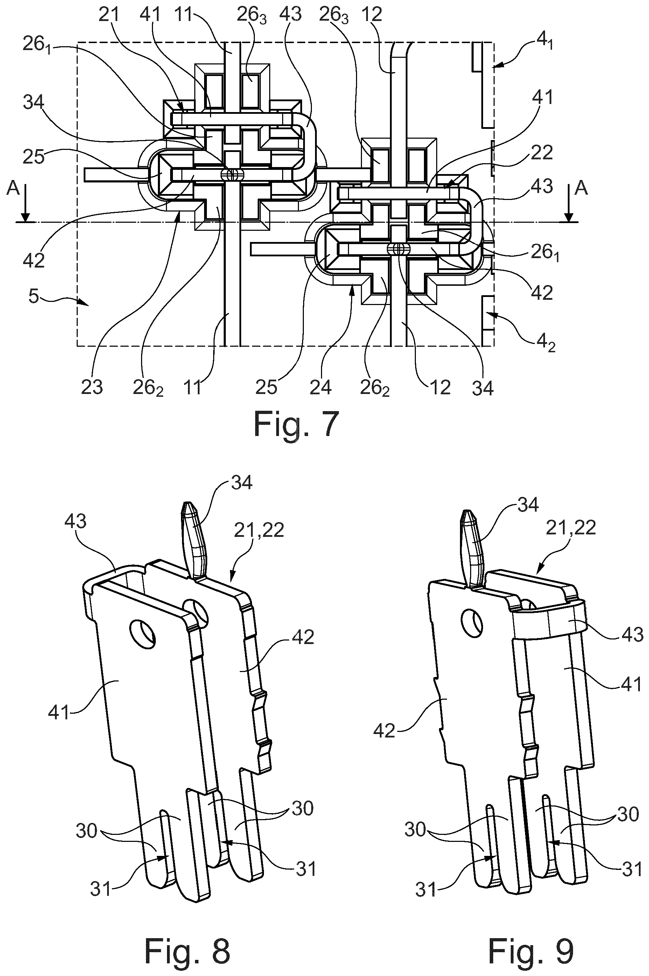

**Figure 7** shows a top view of a further embodiment of the first tower **23** and the second tower **24** on the bottom **5** of housing part **9.** The first insulation displacement connector **21** and the second insulation displacement connector **22** are inserted into the first tower **23** and the second tower **24.** The first electric lines **11** of the first capacitor **4₁** and the second capacitor **4₂** are colinearly arranged in the first tower **23** and are electrically contacted by the first plate-shaped form **41** and second plate-shaped form **42** of the first insulation displacement connector **21.** The second electric lines **12** of the first capacitor **4₁** and the second capacitor **4₂** are colinearly arranged in the second tower **24** and are electrically contacted by the first plate-shaped form **41** and second plate-shaped form **42** of the second insulation displacement connector **22.** The second plate-shaped form **42** of first insulation displacement connector **21** and second insulation displacement connector **22** has a connector **34** that provides an electric connection to a printed circuit board (not shown). The first insulation displacement connector **21** and the second insulation displacement connector **22** are mounted with its second plate-shaped form **42** in the slide **25** of the first tower **23** and the second tower **24** in a press-fit manner.

It is shown in the view of Fig. 7 that the first electric lines **11** and the second electric lines **12** from each capacitor are supported by the first support **26₁**, the second support **26₂** or the third support **26₃**. The embodiment of the first insulation displacement connector **21** and the second insulation displacement connector **22** connects, when inserted in the first tower **23** and the second tower **24,** respectively, with its first plate-shaped form **41** and the second plate-shaped form **42** the first electric lines **11** or the second electric lines **12.** The first electric lines **11**and the second electric lines **12** are supported on each side of the first plate-shaped form **41** and the second plate-shaped form **42** of the first insulation displacement connector **21** and the second insulation displacement connector **22.** On each side of the first plate-shaped form **41,** for example, the first electric line **11** form the first capacitor **4₁** is supported by the first support **26₁** and the third support **26₃**. On each side of the second plate-shaped form **42,** for example, the first electric line **11** form the second capacitor **4₂** is supported by the first support **26₁** and the second support **26₂**. The first support **26₁**, the second support **26₂** and the third support **26₃** are necessary in order to have the first electric line **11** and the second electric line **12** stand still when the first insulation displacement connector **21** and the second insulation displacement connector **22** are inserted.

The further embodiment of the first insulation displacement connector **21** and the second insulation displacement connector **22** is shown in **Figure 8** and **9****,** wherein Fig. 9 shows the displacement connectors **21, 22** from the other side than Fig. 8. First insulation displacement connector **21** and second insulation displacement connector **22** each have a first plate-shaped form **41** and a second plate-shaped form **42** that are parallel to each other. First plate-shaped form **41** and second plate-shaped form **42** are each electrically connected to a bracket **43.** Only second plate-shaped form **42** is provided with a connector **34,** i.e. first plate-shaped form **41** is not provided with a connector **34.** The first plate-shaped form **41** and the second plate-shaped form **42** each have at least one slot **31** which is adjoined by fingers **30.**

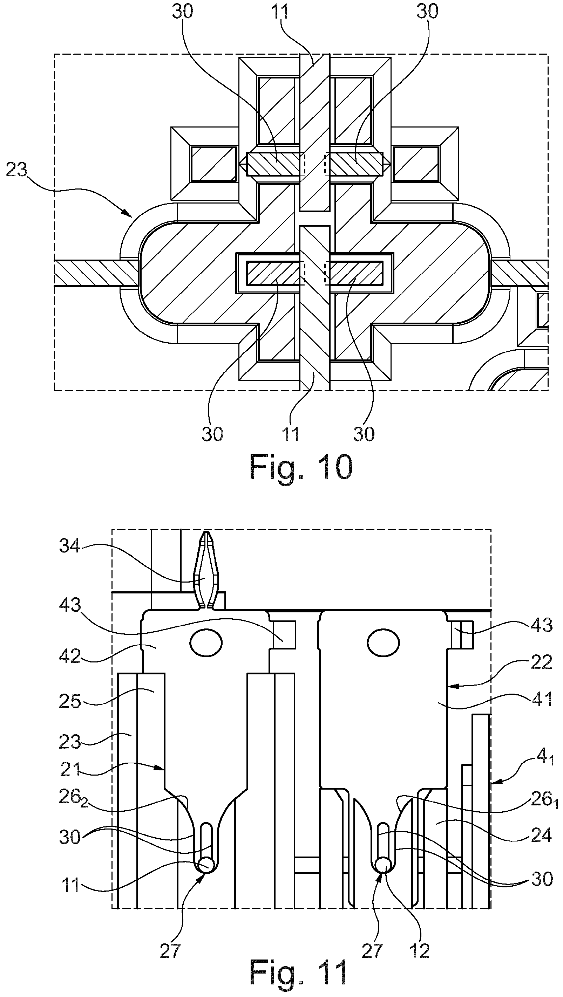

**Figure 10** shows a sectional view of the first tower **23** and the electric contacting of the first electric lines **11** by the first insulation displacement connector **21.** Both electric lines **11** are colinearly arranged in the first tower **23.** Once the first insulation displacement connector **21** is inserted in the first tower **23,** the fingers **30** electrically contact the first electric lines **11** which enter the first tower **23** from opposite sides and are electrically separated from each other.

**Figure 11** shows a sectional view of the embodiments of first tower **23** and second tower **24** along line A-A of Fig. 7. Here, first tower **23** is provided with the inserted first insulation displacement connector **21.** Second tower **24** is provided with an inserted second insulation displacement connector **22.** According to this sectional view, second tower **24** is partially cut away to reveal first plate-shaped form **41** of second insulation displacement connector **22** positioned in second tower **24.** Second plate-shaped form **42** of first insulation displacement connector **21** is inserted into a slide **25** of first tower **23**. First electric line **11** of second capacitor **4₂** (not shown here) is placed on a groove **27** of a first support **26₁** and the second support **26₂** of first tower **23.** The fingers **30** of second plate-shaped form **42** of first insulation displacement connector **21** contact the first electric line **11** of the second capacitor **4₂**. The second electric line **12** of capacitor **4₁** is placed on a groove **27** of the first support **26₁** and a third support (not shown here) of second tower **24.** The fingers **30** of first plate-shaped form **41** of second insulation displacement connector **22** contact the second electric line **12** of the first capacitor **4₁**.

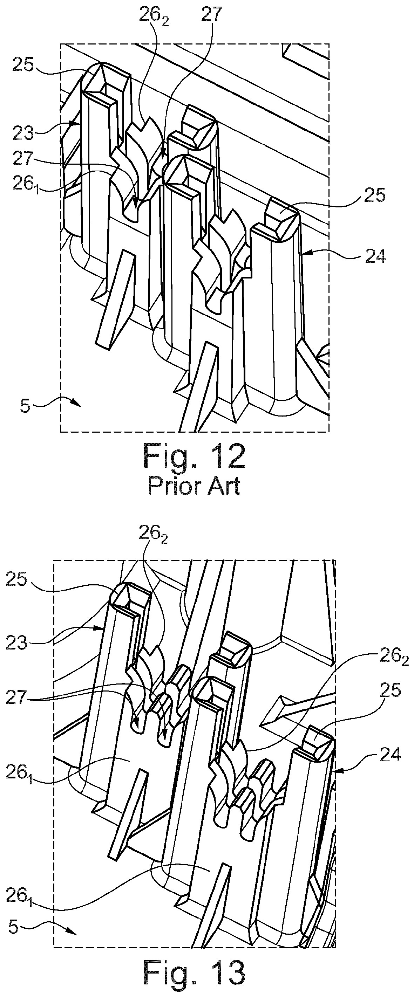

**Figure 12** shows a perspective view of a prior art embodiment of the first tower **23** and the second tower **24** for receiving the prior art first insulation displacement connector **21** and the prior art second insulation displacement connector **22** according to the prior art embodiment as shown in Fig. 5. The first tower **23** and the second tower **24** each have a slide **25** formed to receive the first insulation displacement connector **21** and the second insulation displacement connector **22,** respectively. On one side of slide **25** of first tower **23** and second tower **24,** a first support **26₁** is formed, and on the other side of slide **25,** a second support **26₂** is formed. The first support **26₁** and the second support **26₂** each have a groove **27** formed to receive the first electric line **11** and the second electric line **12,** respectively.

**Figure 13** shows a perspective view of an embodiment of the present invention. Here, the first tower **23** and the second tower **24** receive the first insulation displacement connector **21** and the second insulation displacement connector **22,** respectively. The embodiment of the first insulation displacement connector **21** and the second insulation displacement connector **22** is shown in Fig. 4. The first tower **23** and the second tower **24** have a slide **25** formed to receive the first insulation displacement connector **21** and the second insulation displacement connector **22,** respectively. A first support **26₁** is formed on one side of the slide **25** of the first tower **23** and the second tower **24,** and a second support **26₂** is formed on the other side of the slide **25.** According to the embodiment shown here, the first support **26₁** and the second support **26₂** each have two grooves **27** formed for receiving the first electric line **11** and the second electric line **12,** respectively. As mentioned above, the number of grooves **27** should not be considered as a limitation of the invention.

It is obvious to the person skilled in the art that the number of grooves **27** corresponds to the number of capacitors **4₁**, **4₂,**..., **4_{N}** mounted on the bottom **5** of housing part **9.**

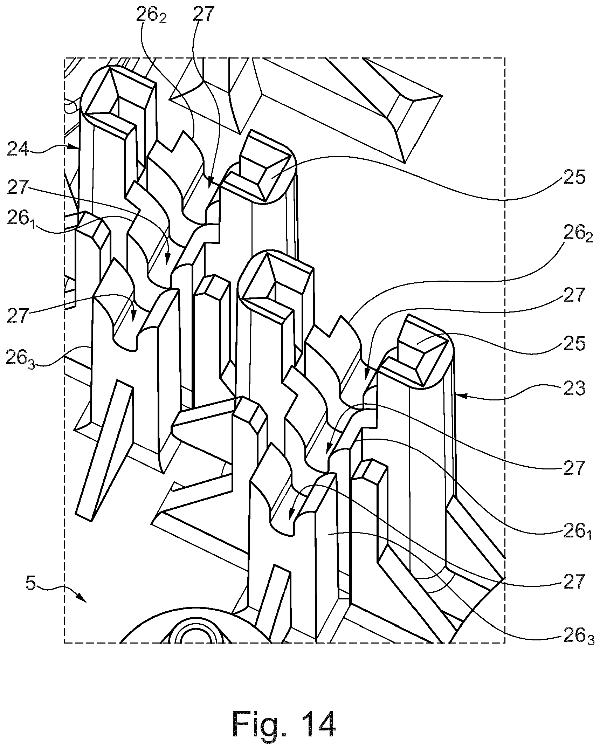

**Figure 14** shows a perspective view of a further embodiment of the first tower **23** and the second tower **24** for receiving the first insulation displacement connector **21** and the second insulation displacement connector **22** according to the embodiment shown in Figs. 8 and 9. The first tower **23** and the second tower **24** each have a slide **25** formed to receive the second plate-shaped form **42** of the first insulation displacement connector **21** and the second insulation displacement connector **22,** respectively. A first support **26₁** is formed on one side of the slide **25** of the first tower **23** and the second tower **24,** and a second support **26₂** is formed on the other side of the slide **25** of the first tower **23** and the second tower **24.** At least one single groove **27** is formed in the first support **26₁** and the second support **26₂**, respectively. Additionally, a third support **26₃** is formed as a part of the first tower **23** and the second tower **24.** The third support **26₃** is separate and spaced apart from the first support **26₁** of the first tower **23** and the second tower **24,** respectively, to receive the first electric line **11** and the second electric line **12.** In the embodiment shown here, one groove **27** is formed in the first support **26₁**, the second support **26₂** and the third support **26₃** of the first tower **23** and the second tower **24.** The grooves **27** of the first support **26₁**, the second support **26₂** and the third support **26₃** are aligned. It is obvious to a person skilled in the art that the first support **26₁**, the second support **26₂** and the third support **26₃** may each have more than one groove **27** that are aligned as well. In case more than two capacitors **4₁**, **4₂**, ...**4_{N}** are placed on the bottom **5** of housing part **9,** the first support **26₁**, the second support **26₂** and the third support **26₃** have more than one groove **27.**

Returning to the embodiment shown in Fig. 14, the first electric line **11** from the capacitors **4₁**, and **4₂** (see Fig. 6) are guided to the first tower **23.** The second electric line **12** from the capacitors **4₁** and **4₂** (see Fig. 6) are guided to the second tower **24.** The first electric line **11** of capacitor **4₁** enters the first tower **23** via the second support **26₃**. The first electric line **11** of capacitor **4₂** enters the first tower **23** via the third support **26₂**. The second electric line **12** of capacitor **4₁** enters the second tower **24** via the second support **26₃**. The second electric line **12** of the capacitor **4₂** enters the second tower **24** via the third support **26₂**.

### LIST OF REFERENCE NUMERALS

- 1: Electronic control unit (ECU)
- 2: Housing
- 3: Mounting structure, cradle
- 4: Back-up power supply
- 4₁, 4₂, ... 4_{N}: Capacitor
- 5: Bottom
- 8: Notch
- 9: Housing part
- 11: First electric line
- 12: Second electric line
- 16: Vehicle
- 18: Vehicle battery
- 19: Electric line
- 21: First insulation displacement connector
- 22: Second insulation displacement connector
- 23: First tower
- 24: Second tower
- 25: Slide
- 26₁: First support
- 26₂: Second support
- 26₃: Third support
- 27: Groove
- 30: Finger
- 31: Slot
- 32: Barbed hook
- 34: Connector
- 41: First plate-shaped form
- 42: Second plate-shaped form
- 43: Bracket
- A-A: Cut

## Claims

1. An electronic control unit (1) comprising
a back-up power supply (4) defined by at least two capacitors (4₁, 4₂, ...4_{N}), wherein the at least two capacitors (4₁, 4₂, ...4_{N}) are accommodated in a housing part (9) of the electronic control unit (1), and each capacitor (4₁, 4₂, ...4_{N}) has a first electric line (11) and a second electric line (12), and
a first insulation displacement connector (21) positioned in a first tower (23) and a second insulation displacement connector (22) positioned in a second tower (24),
**characterized by**
the first electric line (11) of each capacitor (4₁, 4₂, ...4_{N}) being connected to the first insulation displacement connector (21), and the second electric line (12) is connected to the second insulation displacement connector (22);
the first insulation displacement connector (21) and the second insulation displacement connector (22) each having a plurality of slots (31) formed, the number of which corresponds to the number of capacitors (4₁, 4₂, ...4_{N}) forming the back-up power supply (4);
each of the slots (31) of the first insulation displacement connector (21) being adapted for receiving the first electric line (11) of each capacitor (4₁, 4₂, ...4_{N}), and
each of the slots (31) of the second insulation displacement connector (22) being adapted for receiving the second electric line (12) of each capacitor (4₁, 4₂, ...4_{N}).

2. The electronic control unit (1) according to claim 1, wherein the first tower (23) and the second tower (24) each have a slide (25) formed to receive the first insulation displacement connector (21) and the second insulation displacement connector (22), respectively.

3. The electronic control unit (1) according to claim 2, wherein a first support (26₁) and a second support (26₂) are provided on both sides of the slide (25) of the first tower (23) and the second tower (24).

4. The electronic control unit (1) according to claim 3, wherein a plurality of grooves (27) are formed in the first support (26₁) and in the second support (26₂) of the first tower (23) for supporting the first electric line (11) from the capacitors (4₁, 4₂, ...4_{N}), and a plurality of grooves (27) are formed in the first support (26₁) and in the second support (26₂) of the second tower (24) for supporting the second electric line (12) from the capacitors (4₁, 4₂, ...4_{N}).

5. The electronic control unit (1) according to claim 4, wherein the first insulation displacement connector (21) and the second insulation displacement connector (22) each have a plate-shaped form which fits into the slide (25) of the first tower (23), thereby contacting, with the slots (31) of the plate-shaped form, the first electric lines (11) from the capacitors (4₁, 4₂, ...4_{N}), and which fits into the slide (25) of the second tower (24), thereby contacting, with the slots (31) of the plate-shaped form, the second electric lines (12) from the capacitors (4₁, 4₂, ...4_{N}),
each of the slots (31) of the first insulation displacement connector (21) and the second insulation displacement connector (22) being delimited by a pair of fingers (30).

6. The electronic control unit (1) according to any one of claims 1 to 3, wherein a third support (26₃) is provided in separate relation to the first support (26₁) of the first tower (23) and the second tower (24).

7. The electronic control unit (1) according to claim 6, wherein at least one groove (27) is formed in the first support (26₁), the second support (26₂) and the third support (26₃) of the first tower (23) for supporting the first electric lines (11) from the capacitors (4₁, 4₂, ...4_{N}), and at least one groove (27) is formed in the first support (26₁), the second support (26₂) and the third support (26₃) of the second tower (24) for supporting the second electric lines (12) from the capacitors (4₁, 4₂, ...4_{N}).

8. The electronic control unit (1) according to claim 7, wherein the first insulation displacement connector (21) and the second insulation displacement connector (22) each are composed of a first plate-shaped form (41) and a second plate-shaped form (42) extending parallel to each other and being connected with a bracket (43), the first plate-shaped form (41) and the second plate-shaped form (42) each having at least one slot (31) adjoined by respective two fingers (30).

9. The electronic control unit (1) according to claim 8, wherein the second plate-shaped form (42) fits into the slide (25) of the first tower (23) and the second tower (24), and the first plate-shaped form (41) fits between the first support (26₁) and the third support (26₃).

10. The electronic control unit (1) according to claim 9, wherein the slots (31) of the first plate-shaped form (41) and the second plate-shaped form (42), inserted into the first tower (23), contact the first electric lines (11) from the capacitors (4₁, 4₂, ...4_{N}), and the slots (31) of the first plate-shaped form (41) and the second plate-shaped form (42), inserted in the second tower (24) contact the second electric lines (12) from the capacitors (4₁, 4₂, ...4_{N}).

11. The electronic control unit (1) according to claim 9, wherein the at least one groove (27) of the first support (26₁), the second support (26₂) and the third support (26₃) of the first tower (23) and the second tower (24) are aligned with each other.

## Patentansprüche

1. Eine elektronische Steuereinheit (1) umfassend:
eine Notstromversorgung (4), die durch mindestens zwei Kondensatoren (4₁, 4₂, ..., 4_{N}) definiert ist, wobei die mindestens zwei Kondensatoren (4₁, 4₂, ..., 4_{N}) in einem Gehäuseteil (9) der elektronischen Steuereinheit (1) untergebracht sind und jeder Kondensator (4₁, 4₂, ..., 4_{N}) eine erste elektrische Leitung (11) und eine zweite elektrische Leitung (12) hat, und
einen ersten Schneidklemmverbinder (21), der in einem ersten Turm (23) angeordnet ist, und einen zweiten Schneidklemmverbinder (22), der in einem zweiten Turm (24) angeordnet ist,
**gekennzeichnet dadurch, dass**
die erste elektrische Leitung (11) jedes Kondensators (4₁, 4₂, ..., 4_{N}) mit dem ersten Schneidklemmverbinder (21) verbunden ist und die zweite elektrische Leitung (12) mit dem zweiten Schneidklemmverbinder (22) verbunden ist;
der erste Schneidklemmverbinder (21) und der zweite Schneidklemmverbinder (22) jeweils eine Vielzahl von Schlitzen (31) ausgebildet haben, deren Anzahl der Anzahl von Kondensatoren (4₁, 4₂, ..., 4_{N}) entspricht, die die Notstromversorgung (4) bilden;
wobei jeder der Schlitze (31) des ersten Schneidklemmverbinders (21) geeignet ist, die erste elektrische Leitung (11) jedes Kondensators (4₁, 4₂, ..., 4_{N}) aufzunehmen, und
wobei jeder der Schlitze (31) des zweiten Schneidklemmverbinders (22) geeignet ist, die zweite elektrische Leitung (12) jedes Kondensators (4₁, 4₂, ..., 4_{N}) aufzunehmen.

2. Die elektronische Steuereinheit (1) nach Anspruch 1, wobei der erste Turm (23) und der zweite Turm (24) jeweils ein Gleitstück (25) aufweisen, das zur Aufnahme des ersten Schneidklemmverbinders (21) bzw. des zweiten Schneidklemmverbinders (22) ausgebildet ist.

3. Die elektronische Steuereinheit (1) nach Anspruch 2, wobei eine erste Stütze (26₁) und eine zweite Stütze (26₂) auf beiden Seiten des Gleitstücks (25) des ersten Turms (23) und des zweiten Turms (24) vorgesehen sind.

4. Die elektronische Steuereinheit (1) nach Anspruch 3, wobei eine Vielzahl von Nuten (27) in der ersten Stütze (26₁) und in der zweiten Stütze (26₂) des ersten Turms (23) zur Aufnahme der ersten elektrischen Leitung (11) der Kondensatoren (4₁, 4₂, ..., 4_{N}) ausgebildet sind, und wobei eine Vielzahl von Nuten (27) in der ersten Stütze (26₁) und in der zweiten Stütze (26₂) des zweiten Turms (24) zur Aufnahme der zweiten elektrischen Leitung (12) der Kondensatoren (4₁, 4₂, ..., 4_{N}) ausgebildet sind.

5. Die elektronische Steuereinheit (1) nach Anspruch 4, wobei der erste Schneidklemmverbinder (21) und der zweite Schneidklemmverbinder (22) jeweils eine plattenförmige Form aufweisen, die in das Gleitstück (25) des ersten Turms (23) passt und dabei mit den Schlitzen (31) der plattenförmigen Form die ersten elektrischen Leitungen (11) der Kondensatoren (4₁, 4₂, ..., 4_{N}) kontaktiert, und welche plattenförmige Form in das Gleitstück (25) des zweiten Turms (24) passt und dabei mit den Schlitzen (31) der plattenförmigen Form die zweiten elektrischen Leitungen (12) der Kondensatoren (4₁, 4₂, ..., 4_{N}) kontaktiert,
wobei jeder der Schlitze (31) des ersten Schneidklemmverbinders (21) und des zweiten Schneidklemmverbinders (22) durch ein Paar von Fingern (30) begrenzt ist.

6. Die elektronische Steuereinheit (1) nach einem der Ansprüche 1 bis 3, wobei eine dritte Stütze (26₃) in getrennter Beziehung zur ersten Stütze (26₁) des ersten Turms (23) und des zweiten Turms (24) vorgesehen ist.

7. Die elektronische Steuereinheit (1) nach Anspruch 6, wobei in der ersten Stütze (26₁), der zweiten Stütze (26₂) und der dritten Stütze (26₃) des ersten Turms (23) mindestens eine Nut (27) zur Halterung der ersten elektrischen Leitungen (11) der Kondensatoren (4₁, 4₂, ..., 4_{N}) und mindestens eine Nut (27) in der ersten Stütze (26₁), der zweiten Stütze (26₂) und der dritten Stütze (26₃) des zweiten Turms (24) zur Halterung der zweiten elektrischen Leitungen (12) von den Kondensatoren (4₁, 4₂, ..., 4_{N}) ausgebildet sind.

8. Die elektronische Steuereinheit (1) nach Anspruch 7, wobei der erste Schneidklemmverbinder (21) und der zweite Schneidklemmverbinder (22) jeweils aus einer ersten plattenförmigen Form (41) und einer zweiten plattenförmigen Form (42) bestehen, die sich parallel zueinander erstrecken und mit einem Bügel (43) verbunden sind, wobei die erste plattenförmige Form (41) und die zweite plattenförmige Form (42) jeweils mindestens einen Schlitz (31) aufweisen, an den jeweils zwei Finger (30) anschließen.

9. Die elektronische Steuereinheit (1) nach Anspruch 8, wobei die zweite plattenförmige Form (42) in das Gleitstück (25) des ersten Turms (23) und des zweiten Turms (24) passt und die erste plattenförmige Form (41) zwischen der ersten Stütze (26₁) und der dritten Stütze (26₃) passt.

10. Die elektronische Steuereinheit (1) nach Anspruch 9, wobei die Schlitze (31) der ersten plattenförmigen Form (41) und der zweiten plattenförmigen Form (42), die in den ersten Turm (23) eingesetzt sind, die ersten elektrischen Leitungen (11) der Kondensatoren (4₁, 4₂, ..., 4_{N}) kontaktieren, und wobei die Schlitze (31) der ersten plattenförmigen Form (41) und der zweiten plattenförmigen Form (42), die in den zweiten Turm (24) eingesetzt sind, die zweiten elektrischen Leitungen (12) der Kondensatoren (4₁, 4₂, ..., 4_{N}) kontaktieren.

11. Die elektronische Steuereinheit (1) nach Anspruch 9, wobei die mindestens eine Nut (27) der ersten Stütze (26₁), der zweiten Stütze (26₂) und der dritten Stütze (26₃) des ersten Turms (23) und des zweiten Turms (24) zueinander ausgerichtet sind.

## Revendications

1. Une unité de commande électronique (1) comprenant
une alimentation électrique de secours (4) définie par au moins deux condensateurs (4₁ , 4₂ , ..., 4_{N}), dans laquelle les au moins deux condensateurs (4₁ , 4₂ , ..., 4_{N}) sont logés dans une partie de boîtier (9) de l'unité de commande électronique (1), et chaque condensateur (4₁ , 4₂ , ..., 4_{N}) comporte une première ligne électrique (11) et une deuxième ligne électrique (12) , et
un premier connecteur à déplacement d'isolant (21) positionné dans une première tour (23) et un deuxième connecteur à déplacement d'isolant (22) positionné dans une deuxième tour (24) ,
**caractérisé par**
la première ligne électrique (11) de chaque condensateur (4₁ , 4₂ , ..., 4_{N}) étant connectée au premier connecteur à déplacement d'isolant (21), et la deuxième ligne électrique (12) étant connectée au deuxième connecteur à déplacement d'isolant (22) ;
le premier connecteur à déplacement d'isolant (21) et le deuxième connecteur à déplacement d'isolant (22) comportant chacun une pluralité de fentes (31) dont le nombre correspond au nombre de condensateurs (4₁ , 4₂ , ..., 4_{N}) formant l'alimentation électrique de secours (4) ;
chacune des fentes (31) du premier connecteur à déplacement d'isolant (21) étant adaptée pour recevoir la première ligne électrique (11) de chaque condensateur (4₁ , 4₂ , ..., 4_{N}), et
chacun des fentes (31) du deuxième connecteur à déplacement d'isolant (22) étant adapté pour recevoir la deuxième ligne électrique (12) de chaque condensateur (4₁ , 4₂ , ..., 4_{N}).

2. L'unité de commande électronique (1) selon la revendication 1, dans laquelle la première tour (23) et la deuxième tour (24) comportent chacune une glissière (25) formée pour recevoir respectivement le premier connecteur à déplacement d'isolant (21) et le deuxième connecteur à déplacement d'isolant (22).

3. L'unité de commande électronique (1) selon la revendication 2, dans laquelle un premier support (26₁) et un deuxième support (26₂) sont prévus des deux côtés de la glissière (25) de la première tour (23) et de la deuxième tour (24).

4. L'unité de commande électronique (1) selon la revendication 3, dans laquelle une pluralité de rainures (27) sont formées dans le premier support (26₁) et dans le deuxième support (26₂) de la première tour (23) pour supporter la première ligne électrique (11) des condensateurs (4₁ , 4₂, ..., 4_{N}), et dans laquelle une pluralité de rainures (27) sont formées dans le premier support (26₁) et dans le deuxième support (26₂) de la deuxième tour (24) pour supporter la deuxième ligne électrique (12) des condensateurs (4₁ , 4₂ , ..., 4_{N}).

5. L'unité de commande électronique (1) selon la revendication 4, dans laquelle le premier connecteur à déplacement d'isolant (21) et le deuxième connecteur à déplacement d'isolant (22) ont chacun une forme en plaque qui s'insère dans la glissière (25) de la première tour (23), entrant ainsi en contact, avec les fentes (31) de la forme en plaque, les premières lignes électriques (11) des condensateurs (4₁ , 4₂ , ..., 4_{N}), et la forme en plaque s'insère dans la glissière (25) de la deuxième tour (24), entrant ainsi en contact, avec les fentes (31) de la forme en plaque, les deuxièmes lignes électriques (12) des condensateurs (4₁ , 4₂ , ..., 4_{N}),
chacune des fentes (31) du premier connecteur à déplacement d'isolant (21) et du deuxième connecteur à déplacement d'isolant (22) étant délimitée par une paire de doigts (30).

6. L'unité de commande électronique (1) selon l'une quelconque des revendications 1 à 3, dans laquelle un troisième support (26₃) est prévu séparément du premier support (26₁) de la première tour (23) et de la deuxième tour (24).

7. L'unité de commande électronique (1) selon la revendication 6, dans laquelle au moins une rainure (27) est formée dans le premier support (26₁), le deuxième support (26₂) et le troisième support (26₃) de la première tour (23) pour supporter les premières lignes électriques (11) des condensateurs (4₁ , 4₂ , ..., 4_{N}), et au moins une rainure (27) est formée dans le premier support (26₁), le deuxième support (26₂) et le troisième support (26₃) de la deuxième tour (24) pour supporter les deuxièmes lignes électriques (12) des condensateurs (4₁ , 4₂ , ..., 4_{N}).

8. L'unité de commande électronique (1) selon la revendication 7, dans laquelle le premier connecteur à déplacement d'isolant (21) et le deuxième connecteur à déplacement d'isolant (22) sont chacun composés d'une première forme en plaque (41) et d'une deuxième forme en plaque (42) s'étendant parallèlement l'une à l'autre et reliées à un support (43), la première forme en plaque (41) et la deuxième forme en plaque (42) comportant chacune au moins une fente (31) flanquée de deux doigts respectifs (30).

9. L'unité de commande électronique (1) selon la revendication 8, dans laquelle la deuxième forme en plaque (42) s'insère dans la glissière (25) de la première tour (23) et de la deuxième tour (24), et la première forme en plaque (41) s'insère entre le premier support (26₁) et le troisième support (26₃).

10. L'unité de commande électronique (1) selon la revendication 9, dans laquelle les fentes (31) de la première forme en plaque (41) et de la deuxième forme en plaque (42), insérées dans la première tour (23), sont en contact avec les premières lignes électriques (11) des condensateurs (4₁ , 4₂ , ...4_{N}), et les fentes (31) de la première forme en plaque (41) et de la deuxième forme en plaque (42), insérées dans la deuxième tour (24), sont en contact avec les deuxièmes lignes électriques (12) des condensateurs (4₁ , 4₂ , ...4_{N}).

11. L'unité de commande électronique (1) selon la revendication 9, dans laquelle la au moins une rainure (27) du premier support (26₁), du deuxième support (26₂) et du troisième support (26₃) de la première tour (23) et de la deuxième tour (24) sont alignées les unes avec les autres.
